Europäisches Patentamt

European Patent Office

Office européen des brevets

(19)

(11) **EP 0 916 957 B1**

(12) **FASCICULE DE BREVET EUROPEEN**

(45) Date de publication et mention
de la délivrance du brevet:
**24.04.2002 Bulletin 2002/17**

(51) Int Cl.7: **G01R 31/28**, G01R 31/316

(21) Numéro de dépôt: **98121544.5**

(22) Date de dépôt: **17.11.1998**

(54) **Procédé et système de test d'un circuit intégré à fonctionnement sans contact, et d'une capacité d'entrée d'un tel circuit intégré**

Verfahren und System zum Testen eines kontaktlos arbeitenden integrierten Schaltkreises und einer Eingangskapazität eines solchen integrierten Schaltkreises

Method and System for testing an integrated circuit with contactless operation and an input capacitance of such an integrated circuit

(84) Etats contractants désignés:
**DE FR GB IT**

(30) Priorité: **18.11.1997 FR 9714685**
**06.05.1998 FR 9805986**

(43) Date de publication de la demande:
**19.05.1999 Bulletin 1999/20**

(73) Titulaire: **STMicroelectronics S.A.**
**92120 Montrouge (FR)**

(72) Inventeur: **Enguent, Jean-Pierre**
**13119 Saint-Savournin (FR)**

(74) Mandataire: **Ballot, Paul Denis Jacques**
**Cabinet Ballot**
**122, rue Edouard Vaillant**
**92593 Levallois-Perret Cedex (FR)**

(56) Documents cités:
**DE-A- 4 215 957**       **GB-A- 2 111 222**

- **PATENT ABSTRACTS OF JAPAN vol. 098, no. 002, 30 janvier 1998 & JP 09 259233 A (MITSUBISHI ELECTRIC CORP;MITSUBISHI DENKI SEMICONDUCTOR SOFTWARE KK), 3 octobre 1997**

## Description

La présente invention concerne un procédé et un système de test d'un circuit intégré comprenant une capacité d'entrée prévue pour former, avec une bobine d'antenne, un circuit récepteur résonant de fréquence propre prédéterminée.

La présente invention concerne de façon générale les circuits intégrés fonctionnant sans contact ou les circuits intégrés à deux modes de fonctionnement, avec ou sans contact.

Le document DE-A-42 15 957 décrit ainsi un circuit intégré fonctionnant avec ou sans contact, le circuit comprenant soit un coupleur à contacts métalliques conducteurs, soit un coupleur inductif et un élément à effet Hall ou galvanomagnétique.

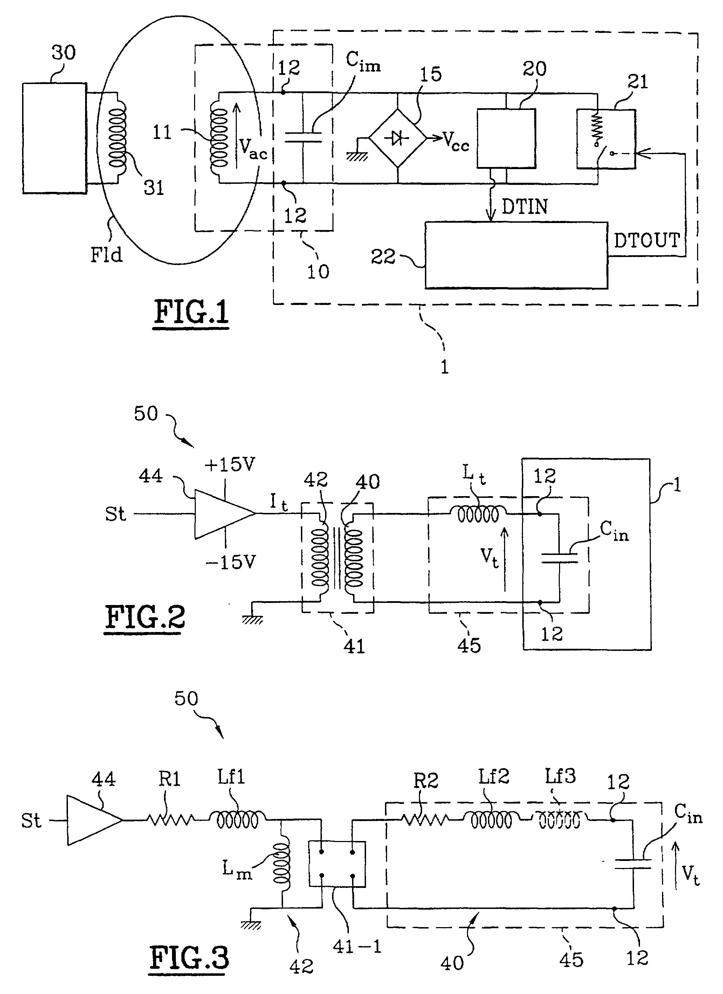

A titre de rappel, la figure 1 représente très schématiquement la structure d'un circuit intégré 1 fonctionnant sans contact, du type monté dans les cartes à puces sans contact, les étiquettes électroniques et autres dispositifs portables fonctionnant sans contact. Le circuit 1 comprend essentiellement un étage d'entrée 10, un circuit redresseur 15, un circuit démodulateur 20, un circuit modulateur 21 et une unité centrale 22 comprenant par exemple un microprocesseur et une mémoire EEPROM. L'étage d'entrée 10 est un circuit résonant parallèle comprenant essentiellement une capacité d'entrée $C_{in}$, intégrée dans le silicium, et au moins une bobine d'antenne 11 connectée aux bornes de la capacité $C_{in}$ par l'intermédiaire de plots de connexion 12. La fréquence de résonance ou fréquence propre Fp de l'étage 10 fait l'objet d'une réglementation et est généralement de 13,56 MHz.

Lorsque le circuit intégré 1 est plongé dans un champ magnétique alternatif Fld de fréquence Fp, émis par exemple par une station 30 équipée d'une bobine 31, une tension alternative Vac apparaît dans la bobine 11 par induction électromagnétique. Cette tension Vac, pouvant atteindre les 40 Volts, est transformée par le circuit redresseur 15 en une tension continue Vcc d'alimentation du circuit intégré. Par ailleurs, la tension Vac est démodulée au moyen du circuit 20 pour la réception de données DTIN, ou modulée par le circuit 21 pour l'émission de données DTOUT à la station 30 selon la technique classique de modulation de charge. Diverses autres techniques classiques peuvent être prévues pour la réception ou l'émission de données, par exemple au moyen de signaux infrarouges, radioélectriques,... Dans tous les cas cependant, l'activation du circuit intégré 1 par induction nécessite que l'étage d'entrée 10 soit excité par un champ magnétique.

Comme les autres circuits intégrés, les circuits sans contact sont fabriqués collectivement sur une plaquette mère de silicium, ou "wafer". Toutefois, à ce stade de la fabrication, l'étage d'entrée 10 n'est pas achevé et ne comprend pas la bobine d'antenne 11. Ce n'est qu'après la découpe de la plaquette mère, quand chaque circuit intégré est monté individuellement sur un support (par exemple une carte plastique), que la bobine d'antenne 11 est connectée à la capacité $C_{in}$ et que l'étage d'entrée 10 devient opérationnel. Les circuits intégrés sont alors activés par un champ magnétique et sont testés électriquement afin d'éliminer ceux qui sont défectueux.

Etant donné que les rendements de fabrication des circuits intégrés sont passables et qu'une plaquette mère contient généralement divers circuits présentant des dysfonctionnements, ce tri des circuits défectueux après montage sur un support et connexion à une bobine d'antenne entraîne un gaspillage important de main d'oeuvre et de matière première, qui grève le coût de revient des dispositifs portables fonctionnant sans contact.

Aussi, la présente invention propose de mettre en oeuvre une méthode de test "sur wafer" permettant d'évaluer les caractéristiques électriques des circuits sans contact avant la découpe des plaquettes mères de silicium.

En pratique, la mise en oeuvre d'une telle méthode de test sur "wafer" nécessite que l'on applique sur l'étage d'entrée de chaque circuit une tension de test simulant la tension alternative Vac reçue par induction. Cette tension de test doit être de l'ordre de 20 à 40 Volts crête à crête et sa fréquence de l'ordre des 13,56 MHz. Or, il s'avère que les générateurs de signaux H.F. les plus performants disponibles dans le commerce délivrent des tensions n'excédant pas les quelques volts, qui ne permettent pas d'activer des circuits intégrés fonctionnant par induction.

Ainsi, un objectif de la présente invention est de prévoir une méthode et un système permettant d'appliquer sur l'étage d'entrée d'un circuit intégré sans contact dépourvu de sa bobine d'antenne une tension de test H.F. pouvant atteindre plusieurs dizaines de volts.

Un autre objectif de la présente invention est de fournir une telle tension avec un courant d'alimentation important, pouvant atteindre la centaine de milliampères ou plus.

Ces objectifs sont atteints grâce à un procédé de test d'un circuit intégré comprenant une capacité d'entrée prévue pour former, avec une bobine d'antenne, un circuit récepteur résonant de fréquence propre prédéterminée, procédé applicable au circuit intégré avant sa connexion à une bobine d'antenne et comprenant les étapes consistant à connecter la capacité d'entrée du circuit intégré à une inductance de test choisie pour former avec la capacité d'entrée un circuit de test résonant ayant une fréquence de résonance sensiblement égale à la fréquence propre dudit circuit récepteur résonant, et exciter le circuit de test résonant au moyen d'un signal alternatif, par l'intermédiaire d'un premier transformateur.

Selon un mode de réalisation, on prévoit un premier transformateur présentant sur son enroulement secondaire une inductance de fuite formant tout ou partie de l'inductance de test.

Selon un mode de réalisation, on prévoit un premier transformateur de type toroïdal dont les enroulements primaire et secondaire ne se recouvrent pas.

Selon un mode de réalisation, l'inductance de test comprend l'inductance parasite d'une liaison électrique présente entre l'enroulement secondaire du premier transformateur et la capacité d'entrée du circuit intégré.

Selon un mode de réalisation, l'enroulement secondaire du premier transformateur est connecté aux bornes de la capacité d'entrée au moyen de pointes métalliques.

Selon un mode de réalisation, le procédé est appliqué au test de la capacité d'entrée du circuit intégré et/ou au test d'un moyen de connexion de la capacité d'entrée à une bobine d'antenne, et comprend les opérations consistant à mesurer le courant traversant le primaire du premier transformateur, et mesurer la tension présente aux bornes de la capacité d'entrée.

Selon un mode de réalisation, le courant traversant le primaire du premier transformateur est mesuré sur le secondaire d'un second transformateur dont le primaire est connecté en série avec le primaire du premier transformateur.

Selon un mode de réalisation, la tension présente aux bornes de la capacité d'entrée est mesurée sur le secondaire d'un troisième transformateur dont le primaire est connecté aux bornes de la capacité d'entrée.

La présente invention prévoit également un système de test d'un circuit intégré comprenant une capacité d'entrée prévue pour former, avec une bobine d'antenne, un circuit récepteur résonant de fréquence propre prédéterminée, système comprenant un premier transformateur connecté par son enroulement primaire à une source de tension ou de courant alternatif, et des moyens de connexion de l'enroulement secondaire du transformateur aux bornes de la capacité d'entrée du circuit intégré.

Selon un mode de réalisation, le premier transformateur présente sur son enroulement secondaire une inductance de fuite formant avec la capacité d'entrée du circuit intégré un circuit de test résonant dont la fréquence de résonance est sensiblement égale à la fréquence propre dudit circuit récepteur résonant.

Selon un mode de réalisation, le circuit de test résonant comprend une inductance parasite présente dans lesdits moyens de connexion.

Selon un mode de réalisation, le système comprend un premier transformateur de type toroïdal.

Selon un mode de réalisation, les moyens de connexion comprennent une carte à circuit imprimé pourvue de pointes métalliques.

Selon un mode de réalisation, le système comprend des moyens de mesure du courant traversant le primaire du premier transformateur, et des moyens de mesure de la tension présente aux bornes de la capacité d'entrée.

Selon un mode de réalisation, les moyens de mesure du courant traversant le primaire du premier transformateur comprennent un second transformateur dont le primaire est connecté en série avec le primaire du premier transformateur.

Selon un mode de réalisation, les moyens de mesure de la tension présente aux bornes de la capacité d'entrée comprennent un troisième transformateur dont le primaire est connecté aux bornes de la capacité d'entrée.

Ces caractéristiques et avantages de la présente invention seront exposés plus en détail dans la description suivante du procédé et du système de test selon l'invention, en relation avec les figures jointes parmi lesquelles :

- la figure 1 précédemment décrite est un schéma électrique représentant sous forme de blocs un circuit intégré sans contact,
- les figures 2 et 3 sont des schémas électriques représentant divers modes de réalisation d'un système de test selon l'invention d'un circuit intégré sans contact dépourvu de sa bobine d'antenne,
- la figure 4 représente très schématiquement un banc de test selon l'invention,
- la figure 5 représente une variante du système de test de la figure 2 permettant le test d'une capacité d'entrée du circuit intégré,
- la figure 6 illustre une application de l'invention au test d'un circuit intégré sans contact connecté à un micromodule de carte à puce.

La figure 2 représente un système de test 50 selon l'invention et illustre le procédé de l'invention. On retrouve sur cette figure le circuit intégré 1 de la figure 1, ici dépourvu de bobine d'antenne. Dans un souci de simplicité, seuls sont représentés la capacité d'entrée $C_{in}$ et les plots de connexion 12.

Selon l'invention, la capacité d'entrée $C_{in}$ du circuit intégré est connectée en série à une inductance de test Lt choisie pour satisfaire la relation

$$(1) \qquad Lt = 1/(4\Pi\, Fp^2\, C_{in}),$$

de manière à former, avec la capacité $C_{in}$, un circuit de test résonnant 45 dont la fréquence de résonance est sensiblement égale à la fréquence Fp. Comme on l'a indiqué au préambule, la fréquence Fp est la fréquence propre de l'étage d'entrée 10 du circuit intégré 1 lorsque celui-ci est équipé d'une bobine d'antenne, et est généralement de 13,56 MHz selon les normes en vigueur. Le circuit de test 45 ainsi réalisé est connecté à l'enroulement secondaire 40 d'un transformateur 41 recevant sur son enroulement primaire 42 la sortie d'un amplificateur tension/courant 44. L'amplificateur 44 est piloté sur son entrée IN par un signal alternatif St d'une amplitude de quelques Volts seulement, de fréquence Fp, et délivre au primaire 42 du transformateur un courant alternatif It de même fréquence.

Ainsi, avantageusement, à partir d'un signal alternatif St de faible valeur et par effet de résonance, on génère aux bornes de la capacité $C_{in}$ une tension de test Vt de grande amplitude pouvant atteindre sans difficulté les 40 Volts crête à crête. La prévision d'un amplificateur 44 présentant une réponse linéaire, alimenté par exemple par des tensions symétriques +15 V et -15 V, permet si cela est nécessaire de fournir au circuit intégré un courant d'alimentation important, de l'ordre de plusieurs centaines de milliampères. Comme autre avantage, le transformateur 41 isole électriquement le circuit intégré de l'amplificateur 44 (la tension de test Vt est flottante) et offre une protection naturelle contre les courts-circuits.

Selon une variante avantageuse du procédé de l'invention illustrée en figure 3, le transformateur 41 vu de son enroulement secondaire 40 est conçu pour présenter une inductance de fuite Lf2 satisfaisant la relation (1) ci-dessus. Dans ce cas, le circuit de test résonant 45 est formé par l'inductance de fuite Lf2 du transformateur et la capacité $C_{in}$. Pour fixer les idées, le transformateur 41 est représenté en figure 3 par son schéma équivalent, établi conformément aux règles de l'art. La référence 41-1 désigne un transformateur idéal. L'enroulement primaire 42 est schématisé par une résistance R1 en série avec une inductance de fuite Lf1 du primaire, et une inductance magnétisante Lm en parallèle. L'enroulement secondaire 40 est schématisé par une résistance R2 (pouvant être considérée comme négligeable) en série avec l'inductance de fuite Lf2, qui constitue ainsi, à elle seule, l'inductance de test Lt.

En pratique, la réalisation d'un transformateur présentant sur son secondaire une inductance de fuite satisfaisant la relation (1) est à la portée de l'homme de l'art et nécessite divers essais de mise au point. L'inductance de fuite peut être ajustée en changeant la géométrie des couches primaires et secondaires du transformateur, et est choisie de préférence à sa valeur maximale (pour une structure de transformateur donnée) de manière que le courant de mode commun à l'entrée du primaire soit le plus faible possible. Selon l'invention, on propose de réaliser un transformateur de type toroïdal dont le noyau est constitué d'une matière présentant, à la fréquence Fp, une bonne perméabilité magnétique et des pertes magnétiques faibles. De préférence, les spires du primaire et du secondaire ne se recouvrent pas afin d'obtenir une inductance de fuite importante. Des essais réalisés par la demanderesse au moyen d'un tore ferromagnétique d'un diamètre de 10 mm en matériau 4C65 Phillips® ont donné de bons résultats. Le transformateur réalisé comportait 10 spires au primaire et au secondaire et une inductance de fuite de l'ordre des 700 nH.

Il convient également de prendre en compte, en pratique, les inductances parasites pouvant apparaître dans la liaison électrique entre l'enroulement secondaire 40 du transformateur et la capacité $C_{in}$. Deux cas peuvent être envisagés. Dans un premier cas, la liaison électrique présente une inductance parasite Lf3 qui ne peut être négligée, représentée en traits pointillés sur la figure 3. Cette inductance parasite Lf3 est alors mesurée et prise en compte lors de la mise au point du transformateur 41. Plus particulièrement, l'inductance de fuite Lf2 du transformateur est proportionnellement diminuée de manière que la somme [Lf2 + Lf3] des deux inductances satisfasse la relation (1). Dans un deuxième cas, on s'arrange pour que l'inductance parasite Lf3 soit faible et négligeable. Ce résultat peut être atteint de façon simple par l'utilisation de fils torsadés ou par la prévision de pistes conductrices agencées d'une manière décrite plus loin.

Il ressort de ce qui précède que la présente invention est susceptible de diverses variantes. L'inductance de test Lt peut être formée par l'inductance de fuite Lf2 du transformateur 41, par l'inductance d'une bobine externe, ou par la combinaison de l'inductance de fuite Lf2 avec l'inductance d'une bobine externe, avec éventuellement la prise en compte de diverses inductances parasites. Par ailleurs, le coefficient de surtension et la bande passante du circuit de test 45 peuvent être ajustés en insérant dans le circuit une résistance électrique série de faible valeur.

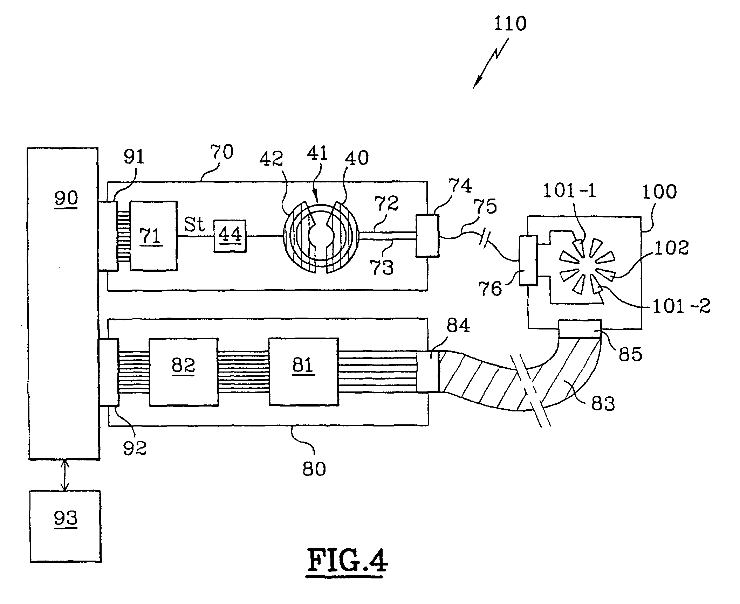

Pour fixer les idées sur la mise en oeuvre industrielle du système 50 qui vient d'être décrit, la figure 4 représente très schématiquement un banc de test 110 selon l'invention. Ce banc 110 permet de tester individuellement des circuits intégrés sans contact présents sur une plaquette mère de silicium. Comme on l'a indiqué au préambule, l'avantage est de pouvoir éliminer des composants défectueux avant leur montage sur un support et leur assemblage avec une bobine d'antenne.

Le banc de test 110 comprend deux cartes à circuit imprimé 70, 80 insérées dans des tiroirs d'une armoire de test 90 par l'intermédiaire de connecteurs 91, 92 dits de "fond de panier", l'ensemble étant relié à un calculateur 93. Essentiellement, la carte 70 comprend un générateur de signaux programmable 71 ainsi que l'amplificateur 44 et le transformateur 41 selon l'invention, ici de type toroïdal. Le générateur 71 est piloté par le calculateur 93 et délivre sur l'entrée l'amplificateur 44 le signal St déjà décrit. A la surface de la carte, deux pistes conductrices 72, 73 relient l'enroulement secondaire 40 du transformateur à un connecteur 74. Ces pistes 72, 73 sont agencées très proches l'une de l'autre afin d'empêcher la formation d'un champ magnétique parasite, et présentent ainsi une inductance parasite négligeable. La carte 70 est reliée par l'intermédiaire du connecteur 74, d'un câble électrique 75 et d'un connecteur 76 à une carte 100 décrite plus loin. Le câble électrique 75 est constitué de fils torsadés de manière à présenter une inductance parasite négligeable.

La carte 80 comprend des moyens 81 de mesure de signaux électriques et des moyens 82 d'échantillonnage et de conversion numérique des signaux mesurés, l'ensemble étant piloté par le calculateur 93. Les moyens de mesure 81 sont reliés à la carte 100 déjà citée par l'intermédiaire d'une nappe de fils 83 et de connecteurs 84, 85.

La carte 100 est une carte à circuit imprimé pourvue de pointes métalliques 101-1, 101-2, 102 agencées pour coïncider avec des plots de test d'un circuit intégré sans contact présent sur une plaquette mère de silicium. On distingue parmi ces pointes métalliques deux pointes 101-1, 101-2 agencées pour coïncider avec les plots de connexion 12 de la capacité d'entrée $C_{in}$ (figure 1). Ces pointes 101-1, 101-2 sont reliées électriquement au secondaire 40 du transformateur 41 par le connecteur 76 et le câble 75. Les autres pointes 102 de la carte 100, dont le nombre est fonction du nombre de plots de test prévus dans le circuit intégré, sont reliées électriquement aux moyens de mesure 81 par l'intermédiaire de la nappe de fils 83.

Ainsi, lorsque la carte 100 est amenée au contact d'un circuit intégré, le secondaire 40 du transformateur 41 se trouve connecté à la capacité $C_{in}$ par l'intermédiaire des pointes métalliques 101-1, 101-2 et le circuit de test 45 représenté en figure 3 est opérationnel. Le circuit intégré peut être activé comme s'il se trouvait dans des conditions réelles de fonctionnement. Par exemple, le générateur programmable 71 peut délivrer, sous le contrôle du calculateur 93, un signal St modulé en amplitude simulant un transfert de données numériques. La tension survoltée de test Vt reçue par le circuit intégré recopie cette modulation d'amplitude. Les pointes métalliques 102 permettent d'observer divers signaux électriques apparaissant dans le circuit intégré et le calculateur 93 peut procéder à une analyse précise de son fonctionnement. L'opération est réalisée de façon récurrente sur tous les circuits intégrés présents sur une plaquette mère de silicium.

Dans ce qui précède, on a considéré uniquement un circuit intégré fonctionnant sans contact. Il doit toutefois être noté que la présente invention s'applique également aux circuits intégrés à deux modes de fonctionnement, comportant une partie fonctionnant sans contact au moyen d'une bobine d'antenne et une partie recevant des signaux par l'intermédiaire de plages de contact.

Par ailleurs, il apparaîtra clairement à l'homme de l'art que le système de test selon l'invention est susceptible de nombreuses variantes de réalisation et perfectionnements.

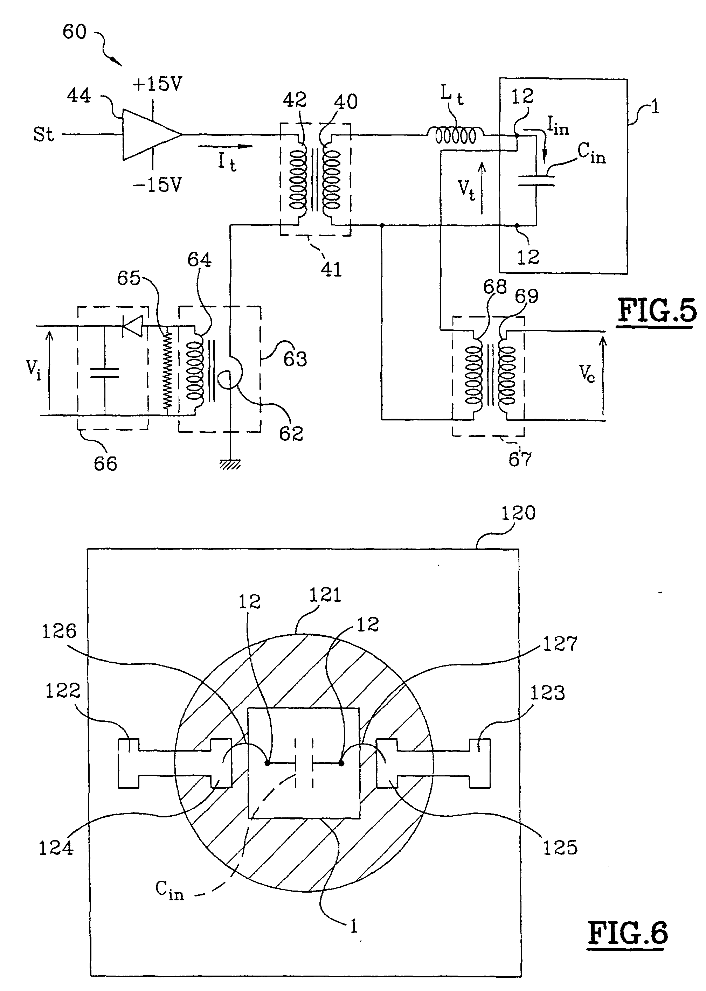

A titre d'exemple, la figure 5 représente une variante de réalisation 60 permettant de mesurer la valeur de la capacité d'entrée $C_{in}$ du circuit intégré 1. On y retrouve dans le système de test 60 l'amplificateur générateur de courant 44, le transformateur 41 et l'inductance de test Lt (par exemple l'inductance de fuite du transformateur 41). Selon l'invention, l'extrémité du primaire 42 du transformateur 41 est connectée à la masse par l'intermédiaire de l'enroulement primaire 62 d'un transformateur 63 formant un moyen simple et pratique de mesure du courant de test It. Ainsi, l'enroulement secondaire 64 du transformateur 63 est connecté en parallèle avec une résistance de charge 65 et un circuit redresseur 66, par exemple un redresseur monoalternance comportant une diode et une capacité. Le redresseur 66 délivre une tension Vi qui est l'image de la valeur crête du courant It, qui est elle-même l'image de la valeur crête du courant $I_{in}$ traversant la capacité $C_{in}$. Du côté du circuit intégré, la tension de test $V_t$ présente aux bornes de la capacité $C_{in}$ est prélevée au moyen d'un transformateur 67 dont l'enroulement primaire 68 est connecté en parallèle avec le secondaire 40 du transformateur 41. Le secondaire 69 du transformateur 67 délivre une tension Vc qui est l'image de la tension Vt.

Selon le mode de réalisation représenté, les transformateurs 41 et 67 comportent le même nombre de spires au primaire et au secondaire, de sorte que la tension Vc est égale à la tension Vt et le courant It égal au courant $I_{in}$. Par ailleurs, le transformateur 63 comporte une spire primaire 62 et dix spires secondaires 64. Ainsi, en régime sinusoïdal, la tension crête Vi délivrée par le redresseur 66 est l'image du courant $I_{in}$ selon la relation suivante :

$$(2) \qquad I_{in} = ((Vi/10)/Rm),$$

Rm étant la valeur de la résistance de charge 65.

Dans ce cas, la valeur de la capacité Cin peut être déduite de la mesure des tensions Vi et Vc, au moyen de la relation suivante :

$$(3) \qquad C_{in} = (((Vi/10)/Rm)/Vc)/\omega$$

soit :

$$(4) \qquad C_{in} = K\ Vi/Vc$$

$\omega$ étant la pulsation du courant de test It et K une constante.

Cet aspect de l'invention permet donc de tester la capacité d'entrée $C_{in}$ avant de lancer l'opération de test proprement dite, et par conséquent de détecter les défaillances éventuelles du procédé de fabrication de la capacité $C_{in}$.

En pratique, les transformateurs 63, 67 sont par exemple disposés sur la carte 70 du système de test de la figure 4 et sont associés à un moyen de calcul du rapport Vi/Vc, délivrant par exemple un signal d'alarme quand ce rapport est en dehors d'une plage de valeurs autorisées. L'inductance de test Lt étant généralement l'inductance de fuite du transformateur 41, une simple connexion du transformateur 67 aux pointes 101-1, 101-2 décrites plus haut permet de mesurer la tension Vt.

Enfin, il apparaîtra clairement à l'homme de l'art que la présente invention est susceptible de diverses applications et n'est pas limitée au test de circuits intégrés présents collectivement sur une plaquette de silicium. La présente invention est de façon générale applicable au test d'un circuit intégré avant sa connexion à une bobine d'antenne. Pour fixer les idées, la figure 6 représente un circuit intégré 1 fixé sur un micromodule 120 de carte à puce et enrobé dans une résine de protection 121. Le micromodule 120 comporte deux plages 122, 123 destinées à être connectées à une antenne au moment du montage du micromodule 120 dans une carte plastique. Les plages 122, 123 sont reliées par des pistes conductrices à des plages 124, 125. Les plages 124, 125 sont connectées aux plots 12 du circuit intégré au moyen de fils 126, 127 soudés aux ultrasons, noyés dans la résine 121. Ici, la mise en oeuvre du procédé de l'invention consiste à appliquer les pointes de test 101-1, 101-2 (fig. 4) aux plages 122, 123. Ainsi, le procédé de l'invention permet non seulement de mesurer la capacité $C_{in}$, d'activer et de tester le circuit intégré, mais également de détecter les défauts de connexion éventuels entre les plages 122, 123 et les plots 12 du circuit intégré, par exemple des défauts de soudure des fils 126, 127.

## Revendications

1. Procédé de test d'un circuit intégré (1) comprenant une capacité d'entrée ($C_{in}$) prévue pour former, avec une bobine d'antenne (11), un circuit récepteur résonant (10) de fréquence propre (Fp) prédéterminée, procédé applicable au circuit intégré avant sa connexion à une bobine d'antenne, **caractérisé en ce qu'**il comprend des étapes consistant à :

   - connecter la capacité d'entrée ($C_{in}$) du circuit intégré à une inductance de test (Lt, Lf2, Lf3, Lf4) choisie pour former avec la capacité d'entrée ($C_{in}$) un circuit de test résonant (45) ayant une fréquence de résonance sensiblement égale à la fréquence propre (Fp) dudit circuit récepteur résonant (10), et
   - exciter le circuit de test résonant (45) au moyen d'un signal alternatif (Iac), par l'intermédiaire d'un premier transformateur (41).

2. Procédé selon la revendication 1, dans lequel on prévoit un premier transformateur (41) présentant sur son enroulement secondaire (40) une inductance de fuite (Lf2) formant tout ou partie de l'inductance de test (Lt).

3. Procédé selon l'une des revendications précédentes, dans lequel on prévoit un premier transformateur (41) de type toroïdal dont les enroulements primaire (42) et secondaire (40) ne se recouvrent pas.

4. Procédé selon l'une des revendications précédentes, dans lequel l'inductance de test (Lt) comprend l'inductance parasite (Lf3) d'une liaison électrique présente entre l'enroulement secondaire (40) du premier transformateur (41) et la capacité d'entrée ($C_{in}$) du circuit intégré.

5. Procédé selon l'une des revendications précédentes, dans lequel l'enroulement secondaire (40) du premier transformateur (41) est connecté aux bornes (12, 122, 123) de la capacité d'entrée ($C_{in}$) au moyen de pointes métalliques (101-1, 101-2).

6. Procédé selon l'une des revendications précédentes, appliqué au test de la capacité d'entrée ($C_{in}$) du circuit intégré et/ou au test d'un moyen (120, 124, 125, 126, 127) de connexion de la capacité d'entrée à une bobine d'antenne (11), comprenant les opérations consistant à :

   - mesurer le courant traversant le primaire (42) du premier transformateur (41), ledit courant primaire étant l'image d'un courant secondaire appliqué à la capacité d'entrée ($C_{in}$), et
   - mesurer la tension (Vt) présente aux bornes (12, 122, 123) de la capacité d'entrée ($C_{in}$).

7. Procédé selon la revendication 6, dans lequel le courant traversant le primaire (42) du premier transformateur (41) est mesuré sur le secondaire (64) d'un second transformateur (63) dont le primaire (62) est connecté en série avec le primaire (42) du premier transformateur (41).

8. Procédé selon l'une des revendications 6 et 7, dans lequel la tension (Vt) présente aux bornes de la capacité d'entrée ($C_{in}$) est mesurée sur le secondaire (69) d'un troisième transformateur (67) dont le primaire (68) est connecté aux bornes (12, 112, 123) de la capacité d'entrée ($C_{in}$).

9. Système de test (50, 110) d'un circuit intégré (1) comprenant une capacité d'entrée ($C_{in}$) prévue pour former, avec une bobine d'antenne (11), un circuit récepteur résonant (10) de fréquence propre (Fp) prédéterminée, **caractérisé en ce qu'**il comprend :

   - un premier transformateur (41) connecté par son enroulement primaire (42) à une source (44, 71) de tension (St) ou de courant (Iac) alternatif, et
   - des moyens (72, 73, 74, 75, 76, 100, 101-1, 101-2) de connexion de l'enroulement secondaire (40) du transformateur (41) aux bornes (12, 122, 133) de la capacité d'entrée ($C_{in}$) du circuit intégré.

**10.** Système selon la revendication 9, dans lequel le premier transformateur (41) présente sur son enroulement secondaire (40) une inductance de fuite (Lf2) formant avec la capacité d'entrée ($C_{in}$) du circuit intégré un circuit de test résonant (45) dont la fréquence de résonance est sensiblement égale à la fréquence propre (Fp) dudit circuit récepteur résonant (10).

**11.** Système selon la revendication 10, dans lequel le circuit de test résonant (45) comprend une inductance parasite (Lf3) présente dans lesdits moyens de connexion (72, 73, 75).

**12.** Système selon l'une des revendications 9 à 11, comprenant un premier transformateur (41) de type toroïdal dont les enroulements primaire (42) et secondaire (40) ne se recouvrent pas.

**13.** Système selon l'une des revendications 9 à 12, dans lequel lesdits moyens de connexion comprennent une carte (100) à circuit imprimé pourvue de pointes métalliques (101-1, 101-2, 102).

**14.** Système selon l'une des revendications 9 à 13, comprenant des moyens (63) de mesure du courant traversant le primaire (42) du premier transformateur (41), et des moyens (67) de mesure de la tension (Vt) présente aux bornes de la capacité d'entrée ($C_{in}$).

**15.** Système selon la revendication 14, dans lequel des moyens (63) de mesure du courant traversant le primaire (42) du premier transformateur (41) comprennent un second transformateur (63) dont le primaire (62) est connecté en série avec le primaire (42) du premier transformateur (41).

**16.** Système selon l'une des revendications 14 et 15, dans lequel les moyens de mesure de la tension (Vt) présente aux bornes de la capacité d'entrée ($C_{in}$) comprennent un troisième transformateur (67) dont le primaire (68) est connecté aux bornes (12, 122, 123) de la capacité d'entrée ($C_{in}$).

**Patentansprüche**

**1.** Verfahren zum Testen eines integrierten Schaltkreises (1) mit einer Eingangskapazität ($C_{in}$), die zusammen mit einer Antennenspule (11) einen resonanten Empfängerkreis (10) mit vorgegebener Eigenfrequenz (Fp) bildet, wobei das Verfahren anwendbar ist auf den integrierten Schaltkreis vor seiner Verbindung mit einer Antennenspule, **gekennzeichnet durch** die folgenden Schritte:

- Verbinden der Eingangskapazität ($C_{in}$) des integrierten Schaltkreises mit einer Testinduktivität (Lt, Lf2, Lf3, Lf4), so daß sich mit der Eingangskapazität ($C_{in}$) ein resonanter Testschaltkreis (45) mit einer Resonanzfrequenz ergibt, die im wesentlichen gleich der Eigenfrequenz (Fp) des resonanten Empfängerkreises (10) ist, und

- Erregen des resonanten Testschaltkreises (45) mittels eines Wechselsignals (Iac) über einen ersten Transformator (41).

**2.** Verfahren nach Anspruch 1, bei dem ein erster Transformator (41) vorgesehen ist, der eine Streuinduktivität (Lf2) aufweist, die die gesamte oder einen Teil der Testinduktivität (Lt) darstellt.

**3.** Verfahren nach einem der vorangehenden Ansprüche, bei dem ein erster toroidaler Transformator (41) vorgesehen ist, dessen Primärwicklung (42) und Sekundärwicklung (40) sich nicht überdecken.

**4.** Verfahren nach einem der vorangehenden Ansprüche, bei dem die Testinduktivität (Lt) eine parasitäre Induktivität (Lf3) aufgrund einer elektrischen Verbindung zwischen der Sekundärwicklung (40) des ersten Transformators (41) und der Eingangskapazität ($C_{in}$) des integrierten Schaltkreises aufweist.

**5.** Verfahren nach einem der vorangehenden Ansprüche, bei dem die Sekundärwicklung (40) des ersten Transformators (41) mit den Anschlüssen (12, 122, 123) der Eingangskapazität ($C_{in}$) mittels metallischer Spitzen (101-1, 101-2) verbunden ist.

**6.** Verfahren nach einem der vorangehenden Ansprüche, das auf den Test der Eingangskapazität ($C_{in}$) des integrierten Schaltkreises und/oder den Test einer Vorrichtung (120, 124, 125, 126, 127) für die Verbindung der Eingangskapazität mit einer Antennenspule (11) angewendet wird und Operationen umfaßt, die bestehen aus:

- Messen des durch die Primärwicklung (42) des ersten Transformators (41) fließenden Stromes, wobei der Primärstrom das Bild eines Sekundärstroms durch die Eingangskapazität ($C_{in}$) ist, und

- Messen der Spannung (Vt) zwischen den Anschlüssen (12, 122, 123) der Eingangskapazität ($C_{in}$).

**7.** Verfahren nach Anspruch 6, bei dem der Strom durch die Primärwicklung (42) des ersten Transformators (41) durch die Sekundärwicklung (64) eines zweiten Transformators (63) gemessen wird, dessen Primärwicklung (62) in Reihe geschaltet ist mit der Primärwicklung (42) des ersten Transformators (41).

**8.** Verfahren nach einem der Ansprüche 6 oder 7, bei dem die Spannung (Vt) zwischen den Anschlüssen der Eingangskapazität ($C_{in}$) gemessen wird über die Sekundärwicklung (69) eines dritten Transformators (67), dessen Primärwicklung (68) mit den Anschlüssen (12, 112, 123) der Eingangskapazität ($C_{in}$) verbunden ist.

**9.** System zum Testen (50, 110) eines integrierten Schaltkreises (1) mit einer Eingangskapazität ($C_{in}$), die mit einer Antennenspule (11) einen resonanten Empfängerkreis (10) bildet, der eine vorgegebene Eigenfrequenz (Fp) aufweist, **gekennzeichnet durch**:

- einen ersten Transformator (41), der über seine Primärwicklung (42) mit einer Wechselspannungs-(St) oder Wechselstrom-(Iac)Quelle (44, 71) verbunden ist, und
- Vorrichtungen (72, 73, 74, 75, 76, 100, 101-1, 101-2) für die Verbindung der Sekundärwicklung (40) des Transformators (41) mit den Anschlüssen (12, 122, 133) der Eigangskapazität ($C_{in}$) des integrierten Schaltkreises.

**10.** System nach Anspruch 9, bei dem der erste Transformator (41) eine Sekundärwicklung (40) mit einer Streuinduktivität (Lf2) umfaßt, die mit der Eingangskapazität ($C_{in}$) des integrierten Schaltkreises einen resonanten Testschaltkreis (45) bildet, dessen Resonanzfrequenz im wesentlichen gleich der Eigenfrequenz (Fp) des resonanten Empfängerkreises (10) ist.

**11.** System nach Anspruch 10, bei dem der resonante Testschaltkreis (45) eine parasitäre Induktivität (Lf3) in den Verbindungsvorrichtungen (72, 73, 75) aufweist.

**12.** System nach einem der Ansprüche 9 bis 11 mit einem ersten toroidalen Transformator (41), dessen Primärwicklung (42) und Sekundärwicklung sich nicht überdecken.

**13.** System nach einem der Ansprüche 9 bis 12, bei dem die Verbindungsvorrichtungen eine Platine (100) mit einer gedruckten Schaltung und metallischen Spitzen (101-1, 101-2, 102) aufweist.

**14.** System nach einem der Ansprüche 9 bis 13 mit Vorrichtungen (63) zum Messen des Stroms durch die Primärwicklung (42) des ersten Transformators (41) und Vorrichtungen (67) zum Messen der Spannung (Vt) an den Anschlüssen der Eingangskapazität ($C_{in}$).

**15.** System nach Anspruch 14, bei dem die Vorrichtungen (63) zum Messen des Stroms durch die Primärwicklung (42) des ersten Transformators (41) einen zweiten Transformator (63) aufweisen, dessen Primärwicklung (62) in Reihe geschaltet ist mit der Primärwicklung (42) des ersten Transformators (41).

**16.** System nach einem der Ansprüche 14 oder 15, bei dem die Vorrichtungen zum Messen der Spannung (Vt) an den Anschlüssen der Eingangskapazität ($C_{in}$) einen dritten Transformator (67) umfassen, dessen Primärwicklung (68) mit den Anschlüssen (12, 122, 123) der Eingangskapazität ($C_{in}$) verbunden ist.

## Claims

**1.** Method for testing an integrated circuit (1) comprising an input capacitor ($C_{in}$) designed to form with an antenna coil (11) a resonant receiving circuit (10) with a predetermined natural frequency (Fp), which method is applicable to the integrated circuit before its connection to an antenna coil, **characterised in that** it comprises steps consisting in:

- connecting the input capacitor ($C_{in}$) of the integrated circuit to a test inductor (Lt, Lf2, Lf3, Lf4) selected to form with the input capacitor ($C_{in}$) a resonant test circuit (45) having a resonance frequency substantially equal to the natural frequency (Fp) of said resonant receiving circuit (10), and
- exciting the resonant test circuit (45) by means of an alternating signal (Iac) through the intermediary of a first transformer (41).

**2.** Method according to claim 1, in which a first transformer (41) is provided having on its secondary winding (40) a leakage inductor (Lf2) forming all or part of the test inductor (Lt).

**3.** Method according to one of the preceding claims, in which a first transformer (41) of toroidal type is provided, the primary winding (42) and secondary winding (40) of which do not overlap.

**4.** Method according to one of the preceding claims, in which the test inductor (Lt) comprises the stray inductor (Lf3) of an electrical connection present between the secondary winding (40) of the first transformer (41) and the input capacitor ($C_{in}$) of the integrated circuit.

**5.** Method according to one of the preceding claims, in which the secondary winding (40) of the first transformer (41) is connected to the terminals (12, 122, 123) of the input capacitor ($C_{in}$) by means of metal spikes (101-1, 101-2).

**6.** Method according to one of the preceding claims, applied to testing the input capacitor ($C_{in}$) of the integrated circuit and/or testing a means (120, 124, 125, 126, 127) for connecting the input capacitor to an antenna coil (11), comprising the operations consisting in:

- measuring the current passing through the primary (42) of the first transformer (41), said primary current being the image of a secondary current applied to the input capacitor ($C_{in}$), and
- measuring the voltage (Vt) present at the terminals (12, 122, 123) of the input capacitor ($C_{in}$).

**7.** Method according to claim 6, in which the current passing through the primary (42) of the first transformer (41) is measured at the secondary (64) of a second transformer (63) the primary (62) of which is connected in series with the primary (42) of the first transformer (41).

**8.** Method according to one of claims 6 and 7, in which the voltage (Vt) present at the terminals of the input capacitor ($C_{in}$) is measured at the secondary (69) of a third transformer (67) the primary (68) of which is connected to the terminals (12, 112, 123) of the input capacitor ($C_{in}$).

**9.** System (50, 110) for testing an integrated circuit (1) comprising an input capacitor ($C_{in}$) designed to form with an antenna coil (11) a resonant receiving circuit (10) with a predetermined natural frequency (Fp), **characterised in that** it comprises:

- a first transformer (41) connected by its primary winding (42) to a source (44, 71) of voltage (St) or alternating current (Iac), and
- means (72, 73, 74, 75, 76, 100, 101-1, 101-2) for connecting the secondary winding (40) of the transformer (41) to the terminals (12, 122, 123) of the input capacitor ($C_{in}$) of the integrated circuit.

**10.** System according to claim 9, in which the first transformer (41) has on its secondary winding (40) a leakage inductor (Lf2) forming with the input capacitor ($C_{in}$) of the integrated circuit a resonant test circuit (45) the resonance frequency of which is substantially equal to the natural frequency (Fp) of said resonant receiving circuit (10).

**11.** System according to claim 10, in which the resonant test circuit (45) comprises a stray inductor (Lf3) present in said connecting means (72, 73, 75).

**12.** System according to one of claims 9 to 11, comprising a first transformer (41) of toroidal type the primary winding (42) and secondary winding (40) of which do not overlap.

**13.** System according to one of claims 9 to 12, in which said connecting means comprise a printed circuit board (100) provided with metal spikes (101-1, 101-2, 102).

**14.** System according to one of claims 9 to 13, comprising means (63) for measuring the current passing through the primary (42) of the first transformer (41), and means (67) for measuring the voltage (Vt) present at the terminals of the input capacitor ($C_{in}$).

**15.** System according to claim 14, in which means (63) for measuring the current passing through the primary (42) of the first transformer (41) comprise a second transformer (63) the primary (62) of which is connected in series with the primary (42) of the first transformer (41).

**16.** System according to one of claims 14 and 15, in which the means for measuring the voltage (Vt) present at the terminals of the input capacitor ($C_{in}$) comprise a third transformer (67) the primary (68) of which is connected to the terminals (12, 122, 123) of the input capacitor ($C_{in}$).

**FIG.1**

**FIG.2**

**FIG.3**

110

90

91  70  42  41  40  74  75  101-1  100

71  St  44  72  73  76  102  101-2

85

82  81  84  83

92  80

93

# FIG.4

60

44   +15V

St ▷

−15V

$I_t$

42   40

41

$L_t$

12

$I_{in}$

$C_{in}$

1

$V_t$

12

**FIG.5**

65   64

63

$V_i$

62

66

68 69

67

$V_c$

120

126   12   121   12   127

122   123

124   125

$C_{in}$

1

**FIG.6**